# FASCICULE DE BREVET EUROPEEN

(11) **EP 0 549 405 B1**
(45) Date de publication et mention de la délivrance du brevet: **26.06.1996**
(21) Numéro de dépôt: 92403398.8
(22) Date de dépôt: 14.12.1992
(51) Int. Cl.: H01L 21/603, H01S 3/025, H01S 3/25

(54) **Procédé de câblage d'une barrette de lasers**
Verfahren zum Verdrahten eines Laserarrays
Method of wiring a laser array

(30) Priorité: 20.12.1991 FR 9115899
(43) Date de publication de la demande: 30.06.1993
(73) Titulaire: THOMSON-CSF MICROELECTRONIQUE, 75008 Paris (FR)
(72) Inventeur: Roustin, Pascal, F-92402 Courbevoie Cedex (FR)
(74) Mandataire: Guérin, Michel

(56) Documents cités:
- US-A- 3 531 735
- IBM TECHNICAL DISCLOSURE BULLETIN vol. 18, no. 10, 10 Mars 1976, IBM CORP., NEW YORK US P.S.ZORY 'Continuous wave laser array'
- PATENT ABSTRACTS OF JAPAN vol. 13, no. 386 (E-812)25 Août 1989
- APPLIED PHYSICS LETTERS. vol. 42, no. 2, Janvier 1983, NEW YORK US pages 152-154 D.E. ACKLEY "Single longitudinal mode operation of high power multiple-stripe injection lasers."
- JAPANESE JOURNAL OF APPLIED PHYSICS (PART 2, LETTERS) vol. 20, no. 3, Mars 1981, TOKYO JP pages 229 - 232 YOSHIO SUZUKI ET AL. '1.5 mum region BH laser array'

## Description

La présente invention concerne un procédé de câblage électrique d'une barrette de lasers semiconducteurs.

On sait que les lasers semiconducteurs sont fabriqués de façon collective, comme tous les semiconducteurs discrets ou intégrés, sur des tranches qui sont ensuite cassées en barres, la cassure ayant pour objet de faire apparaitre les deux faces clivées de la cavité de Fabry-Perrot d'un laser. Selon les cas, ces barres sont à leur tour cassées soit en puces de lasers individuels, soit en barrettes qui réunissent de 10 à 30 lasers par exemple. De telles barrettes permettent de disposer de plus de puissance optique, mais leur alimentation électrique pose quelques problèmes.

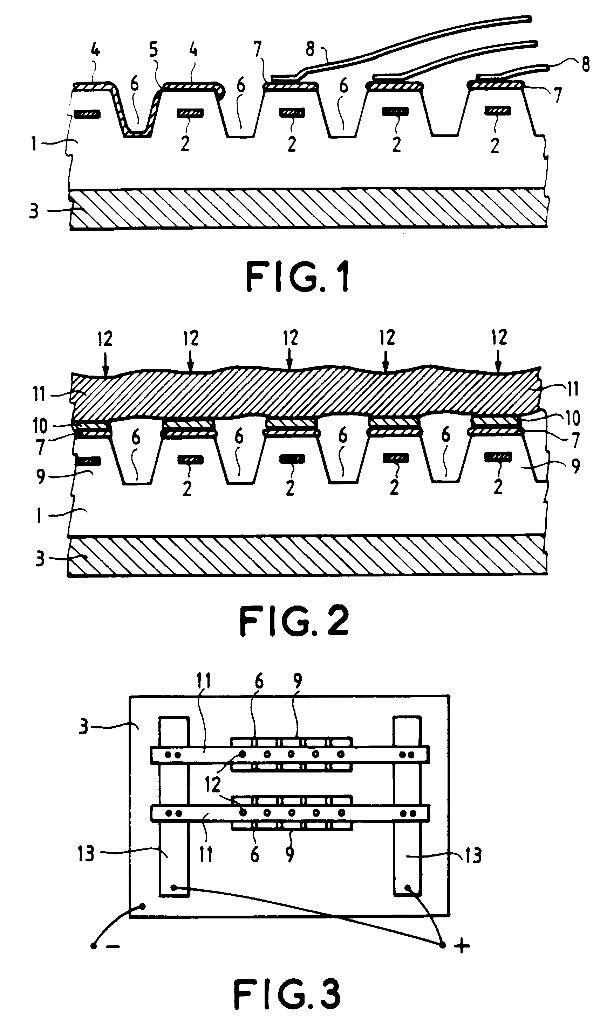

La figure 1 représente une vue en coupe longitudinale d'une barrette, selon l'art connu. Le corps semiconducteur 1 comprend un substrat et une pluralité de couches semiconductrices qui n'ont pas à être détaillées içi : l'objectif de cette structure est de créer des rubans lasers 2 qui émettent un rayonnement lumineux lorsqu'ils sont convenablement polarisés.

Une première borne d'alimentation peut être constituée par un support 3, métallique, sur lequel est brasée la barrette. C'est par exemple la masse.

La seconde borne d'alimentation se trouve sur la face supérieure de la barrette, opposée au support, de façon à ce que le courant électrique traverse les rubans lasers 2. Deux moyens sont connus pour amener le courant sur cette face supérieure. Soit une métallisation 4 est déposée, mais il y a des risques de coupures en 5, sur des arêtes ou des zônes d'ombre, car les rubans lasers 2 sont séparés par des sillons 6, pour canaliser le courant verticalement. Soit des métallisations partielles 7 sont déposées seulement sur les régions de la face supérieure qui dominent les rubans lasers 2, et des fils d'or 8, de 25 µm de diamètre, sont thermocomprimés sur ces métallisations 7. L'alimentation électrique des lasers est individuelle.

Ces solutions individuelles ont, entre autres, deux inconvénients :
- elles n'assurent pratiquement aucune évacuation thermique, bien que les lasers chauffent beaucoup,
- les fils d'or sont de longueurs différentes selon la position du laser élémentaire câblé, et ces différences entraînent des inégalités de potentiel d'alimentation.

Une barrette de lasers de ce type est décrite, par exemple, dans le brevet US-3 531 735, selon lequel la barrette est fixée sur un socle métallique massif qui sert de radiateur, du côté du substrat semiconducteur. Les prises de contact électrique du côté des couches actives se font classiquement par une pluralité de fils, mais ce brevet suggère également que les fils peuvent être remplacés par un feuillard : mais un feuillard est mince et ne peut pas servir de radiateur.

Ces inconvénients sont supprimés par le procédé selon l'invention : les lasers d'une barrette de lasers sont câblés collectivement et alimentés au moyen d'une tige de forme géométrique plus complexe par exemple plate en or, brasée sur les métallisations déposées sur les mésas. Cette tige est épaisse et ne présente qu'une très faible résistance électrique : la tige sert de radiateur et maintient l'égalité du potentiel.

De façon plus précise, l'invention consiste en un procédé de câblage d'une barrette de lasers semiconducteurs, comportant, supportée par un substrat, une pluralité de structures mésas entourant chacune une cavité laser, chaque structure mésa étant recouverte par une métallisation d'électrode ce procédé étant caractérisé en ce qu'il comporte au moins les deux étapes suivantes :
- épaississement des métallisations d'électrodes par recharge électrolytique,
- fixation, par thermocompression sur lesdites métallisations épaissies, d'un ruban métallique épais déposé sur la barrette de lasers dans le sens longitudinal.

L'invention sera mieux comprise par la description suivante d'un exemple d'application, en liaison avec les figures jointes en annexe, qui représentent :
- figure 1 : vue en coupe d'une barrette de lasers, selon l'art connu, qui a été exposée précédemment,
- figure 2 : vue en coupe longitudinale d'une barrette de lasers, alimentés selon le procédé de l'invention,
- figure 3 : vue en plan d'un dispositif comportant deux barrettes alimentées selon le procédé de l'invention.

La figure 2 reprend la même partie de produits semiconducteurs qu'en figure 1. Une barrette de lasers comprend un substrat et des couches semiconductrices 1 qui ne sont pas détaillées içi parce qu'elles ne sont pas nécessaires à l'exposé de l'invention. L'une de ces couches correspond à la couche active dans laquelle sont définies des cavités de Fabry-Perrot, plus couramment désignées rubans lasers 2, dans lesquelles le courant est délimité par :
- les métallisations d'électrodes 7 sur et 3 sous le laser,
- des sillons 6 qui séparent entre eux les rubans d'une même barrette, et forment une pluralité de mésas 9 qui entourent les rubans lasers 2,
- éventuellement une structure ou des caissons isolants ou implantés de part et d'autre - latéralement - des rubans lasers 2.

L'électrode 3 sous la barrette est une plaque métallique qui sert de support : elle peut passer une forte intensité électrique. Il n'en est pas de même de l'électrode 7 déposée sur les mésas 9 : elle a de l'ordre de 0,3 micromètre (µm) d'épaisseur.

La première étape du procédé consiste donc à effectuer une recharge électrolytique de métal, préférentiellement de l'or, en 10, par dessus la métallisation 7. Cette épaisseur de métal 10 permet une thermocompression.

La seconde étape du procédé consiste à amener la polarisation des lasers au moyen d'une tige ou ruban métallique épais 11. Ce ruban d'or 11 a de l'ordre de 400 microns de largeur (c'est à dire selon l'axe des rubans lasers 2) sur 20 microns d'épaisseur. Sa longueur est fonction de la longueur de la barrette elle-même : de l'ordre du centimètre pour une trentaine de lasers élémentaires. Le ruban 11 est thermocomprimé en 12 sur les métallisations 7 + 10, par au moins un point de thermocompression; pour améliorer les contacts thermique et électrique, il est préférable d'opérer plusieurs thermocompressions 12 sur chacun des lasers.

La figure 3 représente un dispositif comportant deux barrettes alimentées selon le procédé de l'invention, ce dispositif étant vu de dessus, pour compléter la coupe de la figure 2. Sur les deux barrettes de lasers, les mésas 9, qui entourent les lasers 2, sont séparés par des sillons 6. Les rubans métalliques 11 sont déposés sur les barrettes de lasers, dans le sens longitudinal puis thermocomprimés en 12.

Pour améliorer l'égalité du potentiel sur tous les lasers élémentaires, le ou les rubans métalliques 11 sont avantageusement connectés sur deux rails métalliques 13, disposés aux deux extrêmités des rubans 11. Bien entendu les rails 13 sont isolés du rapport métallique 3, qui peut être le moyen de fixation et d'orientation des barrettes. Les deux sources de polarisation des lasers sont reliées, par exemple la négative à la plaque support 3 et la positive aux rails 13.

Le procédé peut encore être appliqué à un circuit intégré de lasers : il suffit de répéter l'opération qui s'applique à au moins une barrette.

Outre l'égalité des potentiels, une caractéristique primordiale de l'invention est que le ruban métallique 11 sert de radiateur aux lasers élémentaires, en raison de sa forte masse en comparaison avec des fils d'or.

## Revendications

1. Procédé de câblage d'une barrette de lasers semiconducteurs, comportant, supportée par un substrat (1), une pluralité de structures mésas (9) entourant chacune une cavité laser (2), chaque structure mésa (9) étant recouverte par une métallisation d'électrode (7) ce procédé étant caractérisé en ce qu'il comporte au moins les deux étapes suivantes :
- épaississement (10) des métallisations d'électrodes (7) par recharge électrolytique,
- fixation, par thermocompression (12) sur lesdites métallisations épaissies (7+10), d'un ruban métallique épais (11) déposé sur la barrette de lasers dans le sens longitudinal.

2. Procédé de câblage d'une barrette de lasers semiconducteurs selon la revendication 1, caractérisé en ce que le ruban métallique épais (11) est plus long que la barrette de laser, et en ce qu'une source d'alimentation est appliquée à ses deux extrémités.

3. Procédé de câblage d'une barrette de lasers semiconducteurs selon la revendication 2, caractérisé en ce qu'une seconde source d'alimentation est appliquée sur le substrat (1) conducteur, au moyen d'un support métallique (3) sur lequel est fixée ladite barrette.

## Patentansprüche

1. Verfahren zum Anschließen einer Halbleiterlaser-Leiste, die auf einem Substrat (1) eine Vielzahl von Mesastrukturen (9) aufweist, die je einen Laserhohlraum (2) umgeben, wobei jede Mesastruktur (9) mit einer metallischen Elektrodenschicht (7) bedeckt ist, dadurch gekennzeichnet, daß das Verfahren mindestens die zwei folgenden Schritte aufweist: - Verdickung (10) der Metallschichten (7) der Elektroden durch elektrolytische Abscheidung, - Befestigung eines dicken Metallbands (11), das auf die Laserleiste in Längsrichtung aufgebracht wird, durch Thermokompression (12) auf den verdickten Metallschichten (7 und 10).

2. Verfahren zum Anschließen einer Halbleiterlaser-Leiste nach Anspruch 1, dadurch gekennzeichnet, daß das dicke Metallband (11) länger ist als die Laserleiste und daß eine Stromquelle an seine beiden Enden angelegt wird.

3. Verfahren zum Anschließen einer Halbleiterlaser-Leiste nach Anspruch 2, dadurch gekennzeichnet, daß ein zweiter Stromquellenpol an das leitende Substrat (1) über einen Metallträger (3) angelegt wird, auf dem die Leiste befestigt ist.

## Claims

1. Method of wiring up a linear array of semiconductor lasers, comprising, supported by a substrate (1), a plurality of mesa structures (9) each surrounding a laser cavity (2), each mesa structure (9) being covered by an electrode metallization (7), this method being characterized in that it comprises at least the following two steps:
- thickening (10) the electrode metallizations (7) by electrolytic overlay;
- fixing, by thermocompression (12) on the said thickened metallizations (7+10), a thick metal tape (11) deposited on the linear array of lasers in the longitudinal direction.

2. Method of wiring up a linear array of semiconductor lasers according to Claim 1, characterized in that the thick metal tape (11) is longer than the linear array of lasers and in that a power supply is applied to its two ends.

3. Method of wiring up a linear array of semiconductor lasers according to Claim 2, characterized in that a second power supply is applied to the conductive substrate (1) by means of a metal support (3) to which the said linear array is fixed.
